(19) **Europäisches Patentamt**
**European Patent Office**
**Office européen des brevets**

(11) **EP 2 188 792 B1**

(12) **EUROPEAN PATENT SPECIFICATION**

(45) Date of publication and mention
of the grant of the patent:
**28.08.2019 Bulletin 2019/35**

(51) Int Cl.:
*G08B 13/24* (2006.01)   *H01F 10/13* (2006.01)
*H01L 41/20* (2006.01)

(21) Application number: **07798193.4**

(86) International application number:
**PCT/US2007/070557**

(22) Date of filing: **07.06.2007**

(87) International publication number:
**WO 2007/143707 (13.12.2007 Gazette 2007/50)**

(54) **AMORPHOUS ALLOY COMPOSITIONS FOR A MAGNETOMECHANICAL RESONATOR AND EAS MARKER CONTAINING SAME**

ZUSAMMENSETZUNG EINER AMORPHEN LEGIERUNG FÜR EINEN MAGNETOMECHANISCHEN RESONATOR UND DIESE ENTHALTENDES ELEKTRONISCHES ARTIKELÜBERWACHUNGSETIKETT

COMPOSITIONS D'ALLIAGES AMORPHES POUR RÉSONATEUR MAGNÉTOMÉCANIQUE ET MARQUEUR EAS CONTENANT LESDITES COMPOSITIONS

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**26.05.2010 Bulletin 2010/21**

(60) Divisional application:
**17210712.0 / 3 346 454**

(73) Proprietor: **Sensormatic Electronics, LLC**
**Boca Raton, FL 33487 (US)**

(72) Inventors:
• **LIAN, Ming-Ren**
**Boca Raton, FL 33428 (US)**

• **LIU, Nen-Chin**
**Wellington, FL 33414 (US)**
• **CHINA, Chaitali**
**Orlando, FL 32826 (US)**
• **COFFEY, Kevin R.**
**Oviedo, FL 32766 (US)**

(74) Representative: **Hafner & Kohl**
**Patent- und Rechtsanwaltskanzlei**
**Schleiermacherstraße 25**
**90491 Nürnberg (DE)**

(56) References cited:
**EP-A- 0 702 096      WO-A-90/03652**
**GB-A- 2 156 630**

EP 2 188 792 B1

**Description**

BACKGROUND

The field of this invention is electronic article surveillance and more particularly a marker for use in an electronic article surveillance system.

There are many different sensing technologies used by retailers' anti-theft applications, known as Electronic Article Surveillance ("EAS"). Among these technologies are acoustomagnetic ("AM") based markers (tags and labels), such as those produced by Sensormatic Electronics Corporation, which are highly desirable due to many of their unique advantages, such as high sensitivities, small size, deactivitible / reactivitible, low cost, easy deactivation, etc.

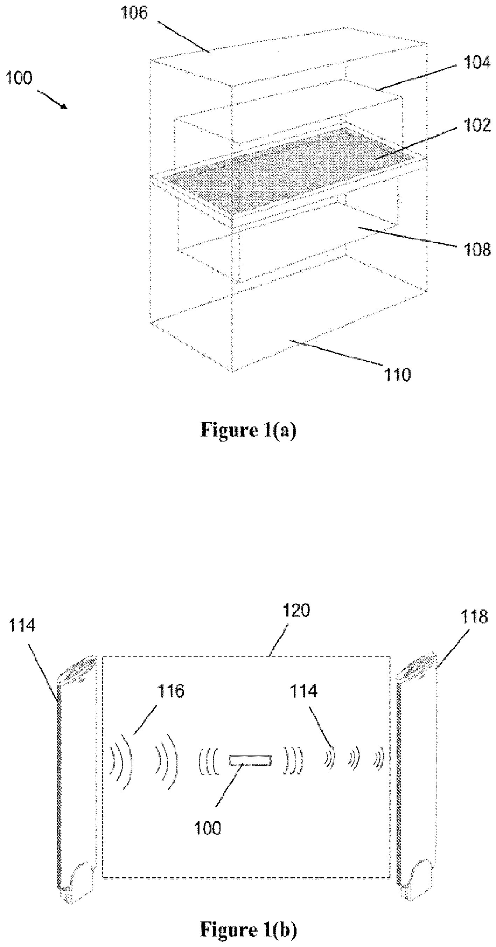

A typical AM label is measured about 45 mm long, 10 mm wide, with an overall thickness of about 1.3 mm. An example of such a label is illustrated in Figure 1. As shown in Figure 1(a), label 100, may include a small cavity 102, which is formed to accommodate one or more active elements 104. Active element 104 is a magnetomechanical metal strip and cavity 102 is formed to allow proper mechanical resonance of the active element. Active element(s) 104 are placed inside cavity 102, and followed by sealing of top cover 106. A strip of semi-hard magnetic bias 108 is located proximate the outside of cavity 102 and active element 104. Finally, marker 100 is completed by adding an adhesive layer with release liner 110.

Figure I(b) illustrates a typical EAS system employing a marker such as AM marker 100. As shown in Figure 1(b), transmitter pedestal 114 generates an electromagnetic field 116 between it and receiver pedestal 118. The field is typically generated in a series of pulses, which produce regular bursts of electromagnetic energy. The range of the magnetic field defines an "interrogation zone"(120) between the pedestals. When passed through this interrogation zone, active element 104 of AM marker 100 absorbs energy from field 116, and resonates to generate an electromagnetic response signal to the incoming electromagnetic energy from transmitter. To accomplish this, active element 104 is comprised of a strip of high permeability ($\mu$) magnetic material. In addition, it is also a high quality factor (Q) mechanical resonator. The Q can be as high as 3000, depending on the surface friction of the strip during its resonance. Receiver pedestal 118 listens for this response signal in between bursts from transmitter 114, in order to detect the presence of a marker within the interrogation zone. When a marker is detected, the system may then trigger an alarm to alert security.

The active element to be used in the marker may be produced by determining a number of factors in order to achieve an element having the desired properties. For example, this can be accomplished through careful selection of the composition from which the element is formed, and the manner in which the composition is annealed and otherwise processed, mechanically, chemically, and electromagnetically. A number of techniques for optimizing the active element of an EAS marker are known. Some of these are disclosed, for example, in U.S. Patent Nos. 4,510,489; 5,252,144; 5,469,140; 5,469,489; 5,628,840; 6,018,296; and 6,359,563.

U.S Patent Nos. 6,018,296 and 6,359,563, for example, disclose an FeNi based alloy having low or no cobalt, and with specified amounts of additional elements, M, (such as Si, B, C, P, Ge, Nb, Mo, Cr and Mn) to control how glassy the material is, its formability, and its susceptibility to changes in magnetic properties due to mechanical tension on the material during annealing.

These patents focus on the use of quick (around 1 minute or less) heating of the material at higher temperatures (> 300°C) in a reel to reel annealing process to set the magnetic characteristics of the material. In the '296 patent, a batch annealing with a heating time of fifteen minutes at these higher temperatures was also used for comparison to the preferred reel-to reel annealing process.

The '296 patent also states that annealing this material in the presence of a transverse (to the length of the active element ribbon) magnetic field is undesirable because a sufficiently low slope of the frequency response characteristic of the material cannot be achieved at the desired DC bias field operating point of about 517.3 Am$^{-1}$ (6.5 Oe). Conversely, the '563 patent, while it is able to achieve a sufficiently low slope for the frequency response characteristic even with the use of a transverse magnetic field, requires the use of reel to reel annealing at these higher temperatures and shorter annealing times.

Outside factors, such as the cost of raw materials (such as Ni) and/or the high cost of various aspects of processing materials (such as higher temperature reel to reel quick annealing) into final form can change over time, causing the problem that the cost of producing an active element for an EAS marker can become too high. Accordingly, a solution is needed in developing new ways of achieving the same or better performance in an active element for EAS markers in the face of the problem of such higher costs.

EP 0 702 096 A1 discloses the use of magneto-restrictive alloys based on Fe, Co, for surveillance systems with magnetoelastic tags.

GB 2 156 630 A discloses an article surveillance system and markers for use therein. A marker is comprised of a strip of amorphous magnetostrictive ferromagnetic material.

SUMMARY OF THE INVENTION

The invention is defined in independent claim 1.

Preferably, the balance of remaining elements, M, may include one or more selected from the group consisting of Co, Si, B, C, P, Sn, Cu, Ge, Nb, Mo, Cr, Mn, and Mischmetal.

Particularly, the material can include about 15-30% of one or more selected from the group consisting of Si, B, C, and P in order to affect the glassy nature of the material. In order to affect magnetic properties of the material, it may include from 0 to about 10% of one or more selected from the group consisting of Sn, Cu, Ge, Nb, Mo, Cr, Mn, and Mischmetal. The batch annealing is conducted particularly at a temperature of about 250° C for about one hour.

BRIEF DESCRIPTION OF THE DRAWINGS

For a better understanding of various embodiments of the invention, reference should be made to the following detailed description which should be read in conjunction with the following figures wherein like numerals represent like parts.

Figure I(a) is an illustration of the construction of an acoustomagnetic marker.

Figure 1(b) is an illustration of an EAS system.

Figure 2 is an illustration of the dependency of a typical resonant frequency of an EAS marker on the external applied DC magnetic field [0016] Figure 3 is an illustration of magnetomechanical resonant amplitudes measured at three time slots, $A_0$, Ai, and $A_2$, with changes with the external DC bias field

Figure 4 is an illustration of the effect of nickel percent concentration on induced field anisotropy in an active element.

Figure 5 is an illustration of the effect of nickel percent concentration on saturation magnetization.

Figure 6 is an illustration of the effect of nickel concentration on Magnitude of magnetostriction.

Figure 7 is an illustration of a comparison of frequency -DC bias dependence of existing active elements for an EAS marker with an active element of the invention.

Figure 8 is an illustration of resonant performance for an EAS marker with an active element.

DETAILED DESCRIPTION

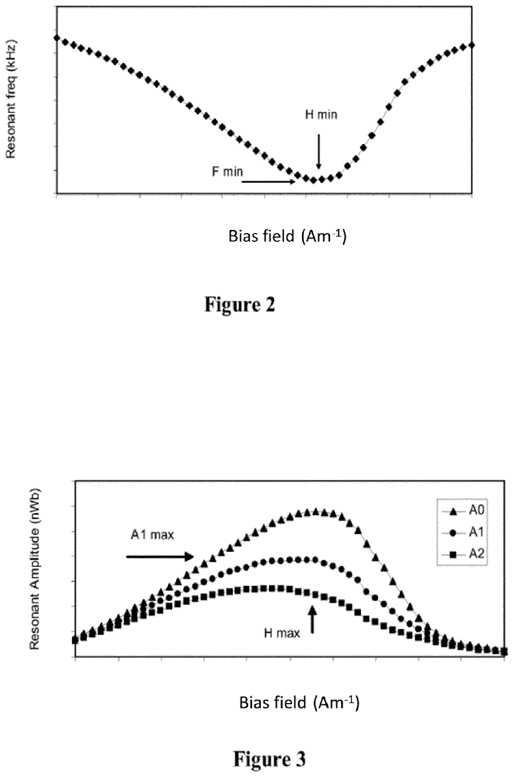

Figure 2 illustrates a typical resonant frequency characteristic of an active element. As can be seen in Figure 2, the resonant frequency of the element varies with the DC field (generated by interaction with the semi-hard bias magnet). As the DC bias field increases, the resonant frequency decreases, until it reaches a minimum ($F_{mm}$) at a bias field of $H_{mm}$ ($Am^{-1}$). The frequency then increases quickly beyond $H_{mm}$. The frequency-bias magnetic field interdependence can be described in Eq. 1:

$$F_{res} = \frac{1}{2L} \cdot \sqrt{\frac{E/\rho}{1 + \frac{9\lambda^2 E \cdot H^2}{M_s \cdot H_k^3}}} \tag{1}$$

where E, L, p are the Young's modulus, length, and density of the amorphous strip, and H, $\lambda$, $M_s$, and $H_k$, are the applied DC magnetic field, magnetostriction, saturation magnetization, and transverse (to the ribbon length) anisotropy field, respectively.

The amplitude characteristic of the response signal can be demonstrated by taking measurements at three time increments (Ao, Ai, $A_2$) after marker 100 is subject to electromagnetic field 116; for example, at 0, 1, and 2 milliseconds after a burst, as shown in Figure 3. In general, the amplitude increases with DC magnetic field, until reaching a maximum at Hmax, and then starts decreasing gradually with bias field, finally diminishing as the active strip saturated magnetically. As shown in Figure 2, the peak Of $A_0$, Ai, and $A_2$ shifts toward left (lower DC field), signifying higher Q at lower magnetic field. In general, Ai amplitude represents what receiver pedestal 116 senses. The maximum of Ai, and the bias field when it occurs, are designated as $Ai_{max}$, and $H_{max}$, respectively.

To obtain a usable active element for an EAS marker, several parameters must be optimized to obtain an operating point for the active element / bias in the marker having a desired resonant frequency (such as 58 kHz for AM markers) at a desired DC bias field, typically less than $H_{mm}$. The frequency slope in Hz / $Am^{-1}$ at this operating point is smaller than the maximum slope for the frequency characteristic curve. The Ai amplitude at the operating point is larger than the minimum amplitude for the amplitude characteristic curve.

For proper function of a deactivatable AM marker, a semi-hard magnetic bias strip is preferably used. This strip is magnetized along the longitudinal direction, in order to provide a DC magnetic field of the desired strength to the active strip. To deactivate the marker, the bias field must be changed to achieve a proper frequency shift. This can be achieved by various methods, including AC demagnetization or magnetization by contacting a patterned magnet. The difference in resonant frequency at the DC bias field of the operating point and the resonant frequency at the DC bias field after deactivation (the deactivation frequency shift, "DFS") should preferably be larger than a selected minimum desired to avoid unintentional detection by receiver pedestal 116. As can be seen from Eq. 1 above, the frequency / bias field relation may be determined by at least three parameters even if the Young's Modulus and density remain relatively consistent among varying compositions. The frequency profile of the resonator should behave similarly as long as the quantity $C = \lambda^2/(M_s H_k^3)$ remains relatively constant.

The anisotropy ($H_k$) has the strongest effect since it is cubic. C will also be affected by $\lambda$ and $M_s$. Depending on the value of C, the anisotropic field may include contribution from field induce anisotropy as well as shape anisotropy.

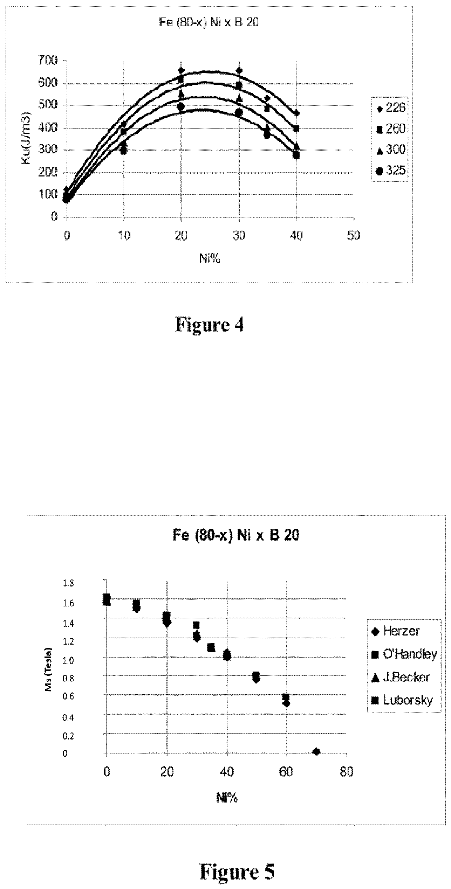

The variation of Ku with Ni at% at different temperatures is shown in Figure 4. $H_k$ is a measure of Ku with contribution of $M_s$ given by $H_k = 2$ Ku/$M_s$. Ku maximizes at around 24% nickel concentration. In addition, Ku also decreases with increased annealing temperature. For an effective short time (around 1 min or less) annealing process, the annealing temperature is set above 300 °C and usually at about 360°C. Under these conditions, the maximum Ku attainable at 30% Ni will be roughly about 410 J/m3.

As shown in Figure 4, however, the field induced $H_k$ of an Fe-Ni active element depends strongly on the Ni concentration, as well as on the annealing conditions, specifically the time and temperature of the annealing process. At a fixed annealing time, $H_k$ increases initially as annealing temperature decreases below material Curie Temperature, reaches a maximum, and then decreases as annealing temperature reduced further. Two competing factors, $M_s(T_a)$ - the saturation magnetization at the annealing temperature ($T_a$) and mobility of atoms in the amorphous alloy create the optimum annealing temperature at which the $H_k$ is maximized. At a lower annealing temperature, the saturation magnetization is higher, thus offers a potential of reaching higher $H_k$. However, at that lower temperature, a longer annealing time is necessary for an effective rearranging of the amorphous material in a short range, microscopic scale.

Therefore, for the Fe-Ni composition having a lower Ni concentration, the desired $H_k$ can still be obtained by lowering the annealing temperature and increasing the annealing time. That is, if a higher field induced anisotropy is desired, annealing with relatively lower annealing temperature, and longer annealing time can be used.

The saturation magnetization is another important parameter. It is directly related to the magnetic signal strength. It also plays a role in forming the resonant frequency and DC magnetic bias relation, as shown in Eq 1. Figure 5 shows the relation of how room temperature saturation magnetization varies with nickel concentration percentage. It is independent of processing / annealing conditions, and decreases monotonically with nickel percent concentration. The anisotropic field (Hk) in this situation may be determined by the following relation:

$$H_k = 2*Ku/M_s \quad (2)$$

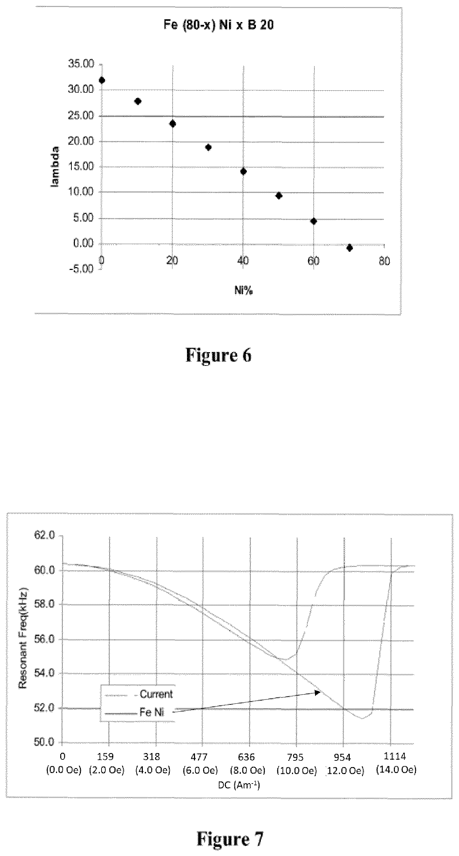

The magnetostrictive constant ($\lambda$s) of the amorphous alloys also depends on Ni atomic percent concentration as shown in Fig. 6. The magnetostrictive constant reduces linearly with increasing Ni % from about 32 ppm at 0% Ni down to about 5 ppm at 60% Ni concentration. [0031] Based on the above information, we have magnetic / mechanical information required to model the magnetomechanical resonance with a Fe-Ni-M amorphous alloy series. A sample composition was modeled comprising Fe55-Ni25-B2o The parameters related to the resonant profile for the active element used in this example are listed in Table 1 below:

Table 1 : Magnetic / mechanical parameters of composition model (1 Oe = 1000/4$\pi$ A.m$^{-1}$; 1 kG = 0.1T);.

| $H_k$(Oe) | $\lambda_s$ (ppm) | $M_s$(kG) | (G Pa) | $\rho$(g/cc) |
|---|---|---|---|---|
| 13.75 | 21 | 13.1 | 162 | 7.76 |

With the material parameters listed in Table 1 , it was determined that a value for C similar to existing active elements could be reached with an $H_k$ value of about 1010.6 Am$^{-1}$ (12.7 Oe) under proper annealing conditions. Figure 7 shows the simulated results on resonant frequency compared to the existing active elements for EAS markers. As shown in Figure 7, the frequency dependence on the DC bias field is very close to the existing elements up to about 716.2 Am$^{-1}$ (9 Oe). In addition, since the saturation magnetization ($M_s$) is much higher, it is expected that the resonant signal magnitude will be higher.

There are also other potential composition variations that can further enhance the strength of the field induce anisotropy. In addition to affecting the glassy nature of the material, a change in the percentage of Si, B, C, and/or P content could potentially increase the Curie temperature of the material which can increase induced $H_k$.

Another potential composition modification to improve the strength of the field induced anisotropy is the addition of low levels of Mn (or, Sn, Cu, Ge, Nb, Mo, and/or Cr). Another approach is to reduce the magnetostriction ($\lambda$) by adding traces of elements, such as chromium (Cr), Niobium (Nb), rare earth Mischmetal - mix of elements). The effect of adding Mn, Cr, or Mo can be to reduce $\lambda_s$, reduce $J_s$, or reduce $H_k$. Mn increases the Creep effect, while Cr reduces it; and Mo has a positive creep effect

Table 2, below, shows data for sputter deposited Fe-Mn-B alloy thin films indicating a significant (238.7 Am$^{-1}$ to 318.3 Am$^{-1}$ (3 to 4 Oe)) increase in $H_k$ for small amount (0.5%) of Mn additions to Fe-B. This increase is much greater than that obtained by Ni additions to Fe-B, which are typically less than 79.6 Am$^{-1}$ (1 Oe) for each atomic % Ni added. To further reduce the materials cost of the alloy, small amounts of Mn could be included in combination with reduced amounts of Ni.

Table 2: Field induced anisotropy of as-deposited sputtered FeMnB alloys (1 Oe = 1000/4$\pi$ A.m$^{-1}$).

| %Fe | %B | %Mn | $H_k$ |
|------|------|------|-------|
| 80 | 20 | 0 | 11.76 |
| 79.5 | 20 | 0.5 | 15.35 |
| 73 | 27 | 0 | 10.57 |
| 72.5 | 27 | 0.5 | 14.53 |

Several samples were prepared and tested to demonstrate the invention. These samples are listed below in Table 3:

Table 3: Sample Compositions; samples 2 and 4-8 are outside the scope of the invention.

| Sample | Composition (atomic %) | Density (g/cc) | Js (T) | $\lambda$s (ppm) |
|--------|-----------------------|----------------|--------|------------------|
| 1 | 58Fc-24Ni-1Si-17B | 7.54 | 1.38 | 30.3 |
| 2 | 52Fe-30Ni-1Si-17B | 7.60 | 1.28 | 26.7 |
| 3 | 54Fe-24Ni-1Si-21B | 7.50 | 1.26 | 24.2 |
| 4 | 48Fe-30Ni-1Si-17B | 7.57 | 1.14 | 20.5 |
| 5 | 53Fe-27Ni-1Si-19B | 7.55 | 1.26 | 24.4 |
| 6 | 52Fe-27Ni-1Mn-1Si-19B | 7.55 | 1.23 | 23.9 |
| 7 | 51Fe-27Ni-2Cr-1Si-19B | 7.54 | 1.13 | 20.6 |
| 8 | 51Fe-27Ni-2Mo-1Si-19B | 7.62 | 1.11 | 19.2 |

These samples were batch annealed, which is much lower in cost to reel to reel annealing. The samples were also subject to a transverse magnetic field during annealing. For different annealing temperatures, different soaking times were used. For 200°C, the soaking time was 2.5 days. At 250°C, the soaking time was at least 7 hours. For 300 and 350°C the soaking time was 10 minutes or more. The resulting $H_k$ for each sample at each annealing temperature is shown in Table 4 below; samples 2 and 4-8 are outside the scope of the invention.

Table 4: Values of $H_k$ at each annealing temperature (1 Oe = 1000/4$\pi$ A.m$^{-1}$)

| Sample# | 1 | 2 | 3 | 4 | 5 | 6 | 7 | 8 |
|---------|------|------|------|------|------|------|------|------|
| 200°C | 12.8 | 13.7 | 9.9 | 9.8 | 11.7 | 10.5 | 9.7 | 9.6 |
| 250°C | 13.3 | 14.4 | 10.5 | 10.9 | 12.0 | 11.3 | 9.6 | 9.2 |
| 300°C | 12.7 | 13.5 | 10.4 | 9.9 | 11.8 | 10.5 | 8.5 | 8.3 |
| 350°C | 11.9 | 12.4 | 10.0 | 9.1 | 11.0 | 9.6 | 7.5 | 6.3 |

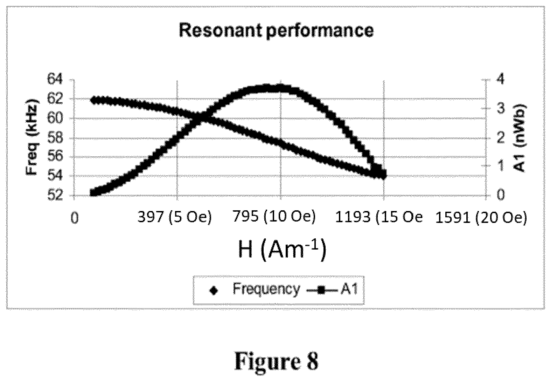

The resonant performance of sample # two, batch annealed in the presence of a transverse magnetic field at 250°C for about one hour is shown in Figure 8. As can be seen from Figure 8 and the preceding information, an active element with parameters that would yield performance on par with existing EAS resonator element can be achieved in a composition having Fe in the range of 40-70 atomic percent, Ni in a range of 10 to less than 25 atomic percent, and the remaining elements in a range of 10-50 atomic percent that is batch annealed in the presence of a transverse magnetic field at a temperature below 300° C and for a time greater than at least one hour.

## Claims

1. A marker (100) for use in a magnetomechanical electronic article surveillance (EAS) system comprising:

   a magnetomechanical active resonator element (104) formed by a planar strip of amorphous magnetostrictive alloy having a composition $Fe_aNi_bM_c$ wherein a+b+c = 100, wherein a is in a range of 40-70 atomic percent, b is in a range of 10 to less than 25 atomic percent, and c is in a range of 10-50 atomic percent, and where M is the balance of remaining elements; wherein M comprises one or more selected from the group consisting of Si, B, C, and P;
   a biasing element (108) located adjacent said resonator element;
   a housing configured to contain said active resonator element (104) and said biasing element (108); and
   wherein said magnetomechanical active resonator element (104) is subject to batch annealing in the presence of a magnetic field that is substantially transverse to the plane of said element and at a temperature of less than 300°C at a time of greater than one hour; wherein
   the frequency slope of the active resonator element (104) in $Hz/A.m^{-1}$ at the operating point is smaller than the maximum slope for the frequency characteristic curve; wherein an amplitude A1 at the operating point is larger than the minimum amplitude for the amplitude characteristic curve.

2. The marker of claim 1, wherein M is one or more selected from the group consisting of Co, Si, B, C, P, Sn, Cu, Ge, Nb, Mo, Cr and Mn.

3. The marker of claim 1, wherein M is from 15 to 30 atomic percent.

4. The marker of claim 1, wherein M comprises one or more first elements selected from the group consisting of Si, B, C, and P to affect the glassy nature of said active element; and one or more second elements selected from the group consisting of Sn, Cu, Ge, Nb, Mo, Cr, Mn and Mischmetal to affect the magnetic properties of said active resonator element (104).

5. The marker of claim 4, wherein said first element comprises 15 to 30 atomic percent of said active resonator element (104), and said second element comprises 0 to 10 atomic percent of said active resonator element (104).

## Patentansprüche

1. Etikett (100) zur Verwendung in einem magnetomechanischen elektronischen Artikelüberwachungssystem (EAS), aufweisend:

   ein magnetomechanisches aktives Resonatorelement (104), welches durch einen flachen Streifen aus amorpher magnetostriktiver Legierung mit einer Zusammensetzung $Fe_aNi_bM_c$ gebildet ist, wobei a+b+c = 100, wobei a in einem Bereich von 40 bis 70 Atomprozent liegt, b in einem Bereich von 10 bis weniger als 25 Atomprozent liegt, und c in einem Bereich von 10 bis 50 Atomprozent liegt, und wobei M des Restgehalt an übrigen Elementen ist; wobei M ein oder mehrere ausgewählt aus der Gruppe bestehend aus Si, B, C und P ist;
   ein Vorspannelement (108), welches benachbart zu dem Resonatorelement angeordnet ist;
   ein Gehäuse, das eingerichtet ist, das aktive Resonatorelement (104) und das Vorspannelement (108) zu enthalten; und
   wobei das magnetomechanische aktive Resonatorelement (104) in Gegenwart eines Magnetfelds, welches im Wesentlichen quer zu der Ebene des Elements verläuft, und bei einer Temperatur von weniger als 300°C in einer Zeit von mehr als einer Stunde einer Haubenglühung unterzogen wird; wobei
   die Frequenzsteigung des aktiven Resonatorelements (104) in $Hz/A.m^{-1}$ am Betriebspunkt geringer als die maximale Steigung für die Frequenzkennlinie ist;
   wobei eine Amplitude A1 am Betriebspunkt größer als die Mindestamplitude für die Amplitudenkennlinie ist.

2. Etikett nach Anspruch 1, wobei M ein oder mehrere ausgewählt aus der Gruppe bestehend aus Co, Si, B, C, P, Sn, Cu, Ge, Nb, Mo, Cr und M ist.

3.  Etikett nach Anspruch 1, wobei M 15 bis 30 Atomprozent beträgt.

4.  Etikett nach Anspruch 1, wobei M ein oder mehrere aus der Gruppe bestehend aus Si, B, C und P ausgewählte erste Elemente aufweist, um die glasartige Beschaffenheit des aktiven Elements zu beeinflussen; und ein oder mehrere aus der Gruppe bestehend aus Sn, Cu, Ge, Nb, Mo, Cr, Mn und Mischmetall ausgewählte zweite Elemente aufweist, um die magnetischen Eigenschaften des aktiven Resonatorelements (104) zu beeinflussen.

5.  Etikett nach Anspruch 4, wobei das erste Element 15 bis 30 Atomprozent des aktiven Resonatorelements (104) aufweist, und das zweite Element 0 bis 10 Atomprozent des aktiven Resonatorelements (104) aufweist.

## Revendications

1.  Marqueur (100) destiné à être utilisé dans un système électronique de surveillance d'articles (EAS selon l'abréviation anglo-saxonne) magnétomagnétique, le marqueur comprenant :

    un élément résonateur actif magnétomagnétique (104) formé par une bande plane d'un alliage magnétostrictif amorphe présentant une composition $Fe_aNi_bM_c$ dans laquelle a+b+c = 100, a étant compris entre 40 et 70 pour cent atomique, b étant compris entre 10 et moins de 25 pour cent atomique et c étant compris entre 10 et 50 pour cent atomique, et M étant le complément des éléments restants ; dans lequel
    M comprend un ou plusieurs éléments choisis dans le groupe constitué par Si, B, C et P ;
    un élément de sollicitation (108) est situé adjacent audit élément résonateur ; une enveloppe est conçue pour contenir ledit élément résonateur actif (104) et ledit élément de sollicitation (108) ; et
    ledit élément résonateur actif magnétomagnétique (104) est soumis à un recuit en paquet en présence d'un champ magnétique sensiblement transversal au plan dudit élément et à une température inférieure à 300 °C pendant un temps supérieur à une heure ;
    le pente de fréquence de l'élément résonateur actif (104) en Hz/A.m$^{-1}$, au niveau du point de fonctionnement, étant inférieure à la pente maximale pour la courbe caractéristique de fréquence ;
    une amplitude A1 au niveau du point de fonctionnement étant supérieure à l'amplitude minimale pour la courbe caractéristique d'amplitude.

2.  Le marqueur de la revendication 1, dans lequel M comprend un ou plusieurs éléments choisis dans le groupe constitué par Co, Si, B, C, P, Sn, Cu, Ge, Nb, Mo, Cr et Mn.

3.  Le marqueur de la revendication 1, dans lequel M est présent en une quantité comprise entre 15 et 30 pour cent atomique.

4.  Le marqueur de la revendication 1, dans lequel M comprend un ou plusieurs premiers éléments choisis dans le groupe constitué par Si, B, C et P afin d'affecter la nature vitreuse dudit élément actif ; et un ou plusieurs seconds éléments choisis dans le groupe constitué par Sn, Cu, Ge, Nb, Mo, Cr, Mn et mischmetal afin d'affecter les propriétés magnétiques dudit élément résonateur actif (104).

5.  Le marqueur de la revendication 4, dans lequel ledit premier élément comprend entre 15 et 30 pour cent atomique dudit élément résonateur actif (104), et ledit second élément comprend entre 0 et 10 pour cent atomique dudit élément résonateur actif (104).

**Figure 1(a)**

**Figure 1(b)**

**Figure 2**

**Figure 3**

**Figure 4**

**Figure 5**

**Figure 6**

**Figure 7**

**Figure 8**

## REFERENCES CITED IN THE DESCRIPTION

**Patent documents cited in the description**

- US 4510489 A
- US 5252144 A
- US 5469140 A
- US 5469489 A
- US 5628840 A
- US 6018296 A
- US 6359563 B
- EP 0702096 A1
- GB 2156630 A